# EUROPEAN PATENT APPLICATION

(11) **EP 4 668 057 A1**
(43) Date of publication of application: **24.12.2025**
(21) Application number: 25183326.5
(22) Date of filing: 17.06.2025
(51) Int. Cl.: G06F 1/20, H01L 23/367, H01L 23/473, H05K 7/20

(54) **LIQUID COOLING SYSTEM**

(30) Priority: 21.06.2024 TW 113206532 U
(71) Applicant: Cooler Master Co., Ltd., Taipei City 114065 (TW)
(72) Inventor: CHAN, CHIA-CHIN, 114065 Taipei City (TW)
(74) Representative: Grünecker Patent- und Rechtsanwälte PartG mbB

(57) **Abstract**

A cooling device containing a cooling liquid includes a heat dissipation plate assembly and a pump. The heat dissipation plate assembly comprises a first plate and a second plate. The first plate features a recessed structure for thermally coupling with a heat source. The second plate covers the recessed structure to form a heat dissipation channel including an inlet and an outlet, among others. The heat dissipation channel accommodates the cooling liquid. The pump is in communication with both the inlet and outlet and serves to circulate the cooling liquid through the channel.

## Description

### BACKGROUND

The present disclosure relates to a cooling device and heat dissipation plate assembly, specifically one in which two plates together form a heat dissipation channel.

With significant technological breakthroughs, the performance of electronic components has significantly improved. However, this also leads to considerable heat generation. To prevent damage from excessive heat, heat dissipation devices must be incorporated into electronic devices to dissipate the heat and allow components to operate within a stable temperature range.

Specifically, manufacturers frequently incorporate water-cooling heat dissipation devices, such as cold plates, into electronic devices. Current water-cooling devices commonly use copper tubes to form the heat dissipation channels, which transport the cooling liquid over the heat source. However, copper tubes require space for bending. If the tube layout is intricate, the bent portions take considerable internal space within the device, complicating the installation of additional components. As a result, the utilization of space in the electronic device is inefficient.

Therefore, a critical concern for developers is how to maintain the efficiency a water-cooling heat dissipation device while enhancing space utilization within electronic devices.

### SUMMARY

In general terms, this disclosure is directed to a cooling device and heat dissipation plate assembly that, while maintaining cooling efficiency, improves internal space utilization in electronic devices.

The invention is as defined in the appended claims.

This summary is provided to introduce a selection of concepts in a simplified form that are further described below in the Detailed Description. This summary is not intended to identify key features or essential features of the claimed subject matter, nor is it intended to be used to limit the scope of the claimed subject matter.

### BRIEF DESCRIPTION OF THE DRAWINGS

FIG. 1 is a perspective schematic view of a cooling device according to one embodiment of the present disclosure.
FIG. 2 is an exploded view of the cooling device.
FIG. 3 is a top view of the cooling device with the second plate omitted.
FIG. 4 is a bottom view of the cooling device.
FIG. 5 is a plan view showing the flow of the cooling liquid in the channel.

### DETAILED DESCRIPTION

Various embodiments will be described in detail with reference to the drawings, wherein like reference numerals represent like parts and assemblies throughout the several views. Reference to various embodiments does not limit the scope of the claims attached hereto. Additionally, any examples set forth in this specification are not intended to be limiting and merely set forth some of the many possible embodiments for the appended claims.

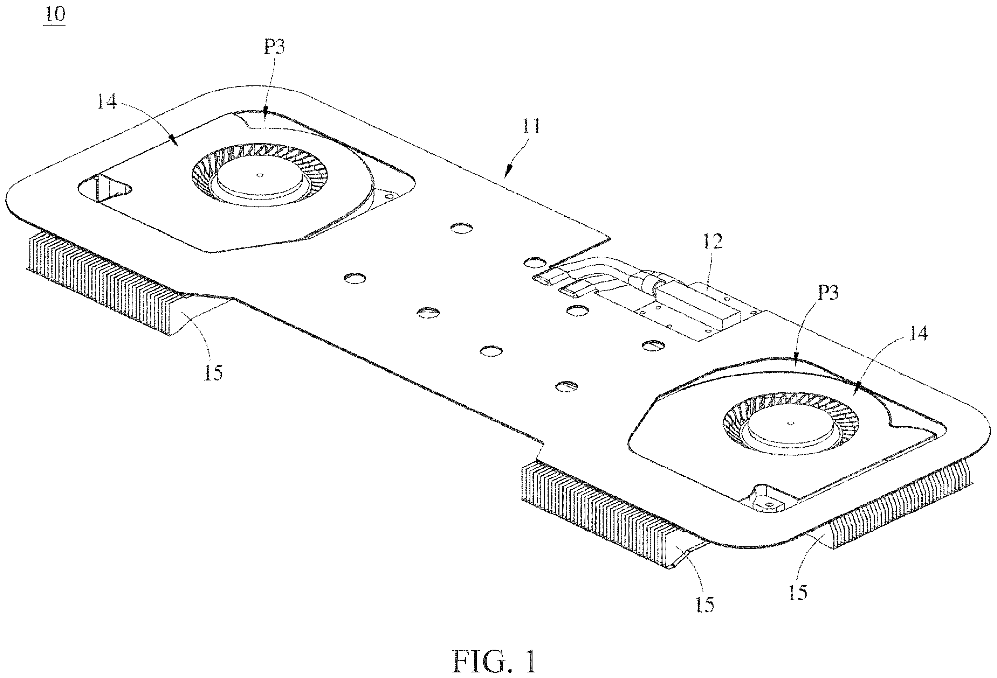

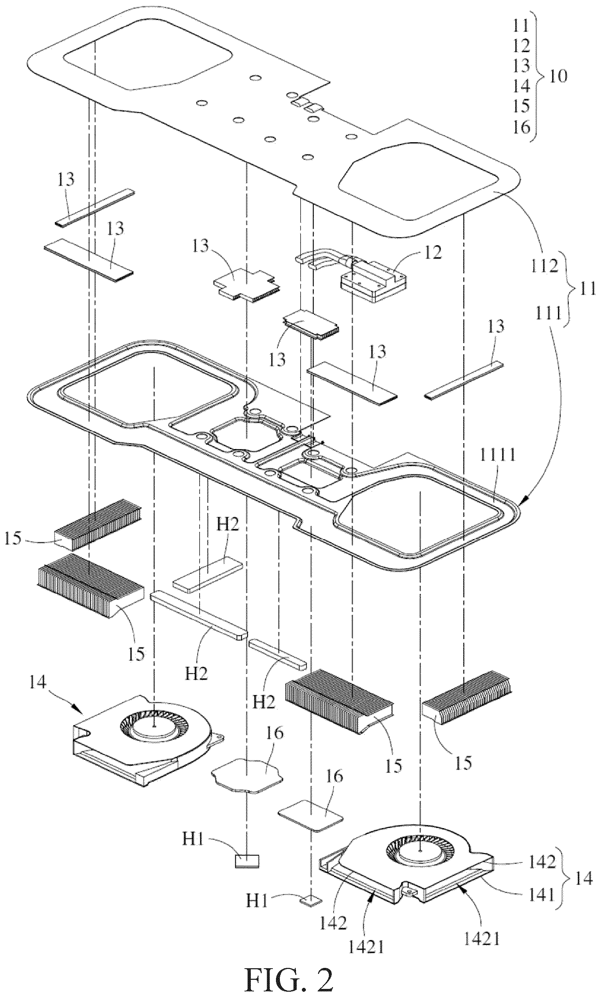

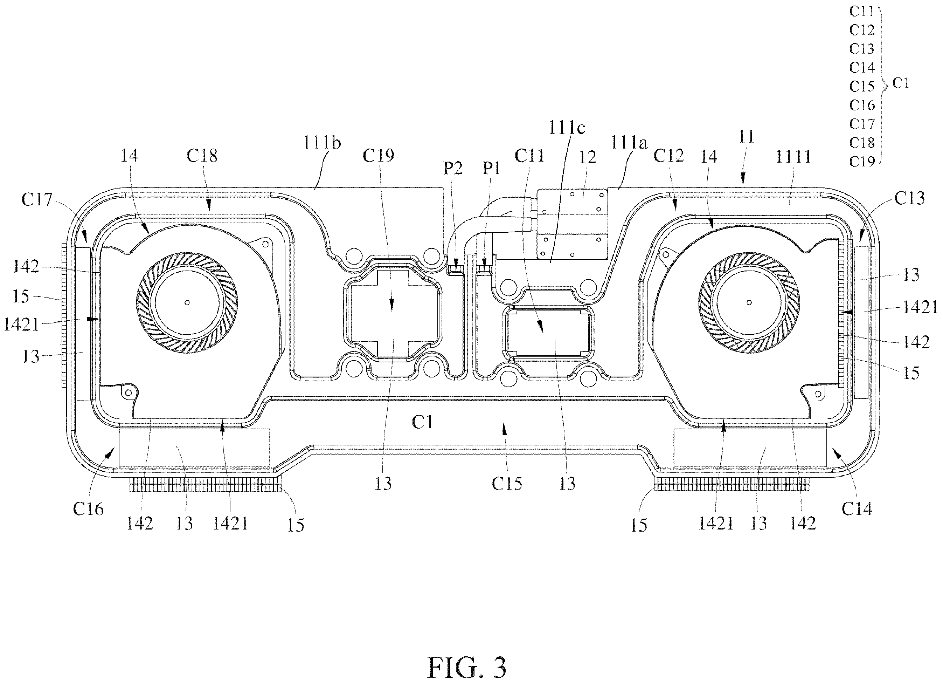

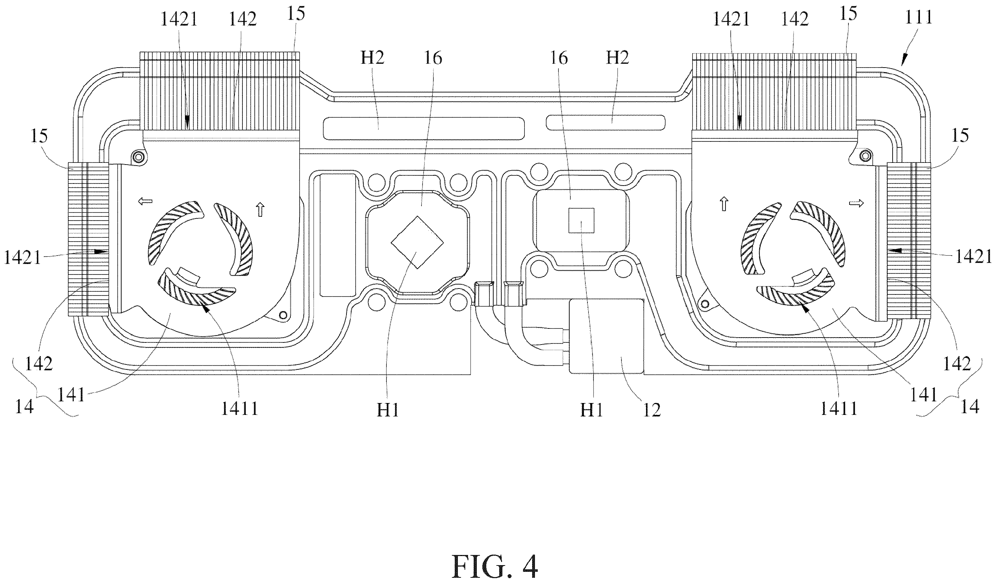

Please refer to Figures 1 to 4. Figure 1 is a perspective view of the cooling device according to an embodiment of the present disclosure. Figure 2 is an exploded view of the cooling device shown in Figure 1. Figure 3 is a top view of the cooling device of Figure 1, with the second plate omitted. Figure 4 is a bottom view of the cooling device of Figure 1.

The cooling device 10 of the present embodiment is configured to contain a cooling liquid (not illustrated) and to be incorporated into an electronic device (not illustrated). The electronic device, for example, could be a laptop computer; the cooling liquid, for example, could be water or a refrigerant. The cooling device 10 includes a heat dissipation plate assembly 11, a pump 12, a plurality of first fins 13, two fan components 14, and a plurality of second fins 15. The heat dissipation plate assembly 11 includes a first plate 111 and a second plate 112. For example, the first plate 111 and the second plate 112 could be connected via welding or any other suitable means.

The first plate 111 has a recessed structure 1111 for thermal coupling to two main heat sources H1, facilitating heat dissipation from the heat sources. The two main heat sources H1, for example, could be a CPU and a GPU. The term "thermal coupling" refers to thermal contact or a connection via another thermally conductive medium. The second plate 112 covers the recessed structure 1111, collectively establishing a heat dissipation channel C1, an inlet P1, and an outlet P2. The heat dissipation channel C1 is used to contain the cooling liquid. The inlet P1 and the outlet P2 are in fluid communication with the heat dissipation channel C1. The pump 12 is in fluid communication with the inlet P1 and the outlet P2 and is used to drive the cooling liquid to circulate within the heat dissipation channel C1.

In some examples, the heat dissipation channel C1 has a first heat absorption section C11, a first connecting section C12, a first heat dissipation section C13, a second heat dissipation section C14, a second connecting section C15, a third heat dissipation section C16, a fourth heat dissipation section C17, a third connecting section C18, and a second heat absorption section C19. One end of the first heat absorption section C11 is in fluid communication with the inlet P1. The other end of the first heat absorption section C11 is in fluid communication with one end of the first connecting section C12. The other end of the first connecting section C12 is in fluid communication with one end of the first heat dissipation section C13. The other end of the first heat dissipation section C13 is in fluid communication with one end of the second heat dissipation section C14. The other end of the second heat dissipation section C14 is in fluid communication with one end of the second connecting section C15. The other end of the second connecting section C15 is in fluid communication with one end of the third heat dissipation section C16. The other end of the third heat dissipation section C16 is in fluid communication with one end of the fourth heat dissipation section C17. The other end of the fourth heat dissipation section C17 is in fluid communication with one end of the third connecting section C18. The other end of the third connecting section C18 is in fluid communication with one end of the second heat absorption section C19. The other end of the second heat absorption section C19 is in fluid communication with the outlet P2. For example, one of the two main heat sources H1 such as a CPU could be thermally coupled to the first heat absorption section C11, and the other such as a GPU could be thermally coupled to the second heat absorption section C19; however, the embodiment is not limited to this.

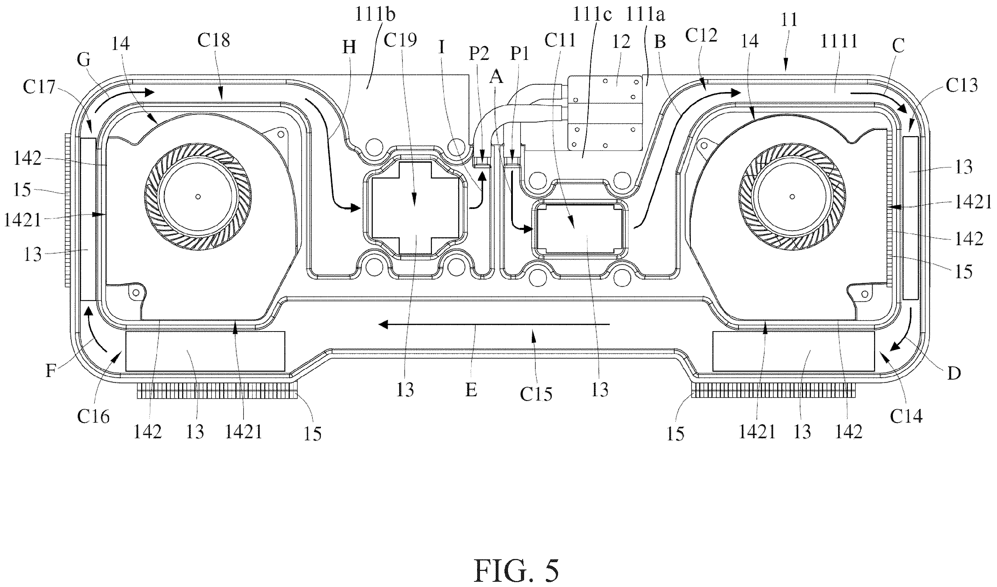

In the present embodiment, since the heat dissipation plate assembly 11 is incorporated into the cooling device 10 and forms the heat dissipation channel C1 through the recessed structure 1111, the bent portions of the flow channel occupy minimal space within the electronic device due to structural constraints. Thus, a more intricate heat dissipation pathway can be designed to optimize the internal space of the electronic device without compromising the placement of other electronic components. This approach enhances the utilization of space within the electronic device while maintaining the cooling efficiency of the cooling device 10. In some embodiments, the recessed structure 1111 includes at least one curved transition, which can be formed using a stamping process. This ensures a seamless transition of the cooling flows (*e.g.*, transition in direction C, D, F, or G shown in Figure 5), thereby enhancing heat dissipation efficiency and increasing the structural flexibility of the heat dissipation pathway.

In another embodiment, the second connecting section C15 of the heat dissipation channel C1 could also be thermally coupled to a plurality of secondary heat sources H2 to dissipate heat from the secondary heat sources H2; however, this is not limited. These secondary heat sources H2 for example, could be electronic components other than the CPU and GPU.

In the present embodiment, the width of either the second heat dissipation section C14 or the third heat dissipation section C16 is greater than the width of the first connecting section C12, the first heat dissipation section C13, the fourth heat dissipation section C17, or the third connecting section C18. The width of either the first heat absorption section C11 or the second heat absorption section C19 is greater than that of either the second heat dissipation section C14 or the third heat dissipation section C16. Furthermore, for example, the first heat dissipation section C13 and the second heat dissipation section C14 maintain linearly symmetrical to the third heat dissipation section C16 and the fourth heat dissipation section C17, aligning with the specifications of the two fan components 14. Additionally, the recessed depth of either the first heat absorption section C11 or the second heat absorption section C19 is greater than that of the first heat dissipation section C13, the second heat dissipation section C14, the third heat dissipation section C16, the fourth heat dissipation section C17, the first connecting section C12, the second connecting section C15, or the third connecting section C18.

The first fins 13 are respectively disposed on the first heat absorption section C11, the first heat dissipation section C13, the second heat dissipation section C14, the third heat dissipation section C16, the fourth heat dissipation section C17, and the second heat absorption section C19. These first fins 13, for example, could be made of copper. Moreover, the widths of the first fins 13 disposed on the first heat dissipation section C13, the second heat dissipation section C14, the third heat dissipation section C16, and the fourth heat dissipation section C17 are each the same as the widths of their corresponding sections, facilitating uniform flow of the cooling liquid through the first fins 13. The inclusion of these first fins 13 enhances the heat exchange efficiency during the flow of the cooling liquid through the first heat absorption section C11, the first heat dissipation section C13, the second heat dissipation section C14, the third heat dissipation section C16, the fourth heat dissipation section C17, and the second heat absorption section C19.

The first plate 111 and the second plate 112 together form two ventilation ports P3. The two ventilation ports P3 are separate from the heat dissipation channel C1. Two fan components 14 are respectively disposed at the two ventilation ports P3. Each fan component 14 includes a base 141 and two side portions 142. The two side portions 142 are connected to the base 141 and are adjacent to each other. The base 141 has an air inlet 1411, and each side portion 142 has an air outlet 1421. Each fan component 14 has two air outlets 1421 divided into a main outlet corresponding to the wider heat dissipation section and a secondary outlet corresponding to the narrower heat dissipation section. Namely, one fan component 14 has two air outlets 1421 corresponding to the narrower first heat dissipation section C13 and the wider second heat dissipation section C14, and the other fan component 14 has two air outlets 1421 corresponding to the narrower fourth heat dissipation section C17 and the wider third heat dissipation section C16. The second fins 15 are disposed on one side of the first plate 111 facing away the second plate 112 and are respectively located at the positions adjacent to the two air outlets 1421. These second fins 15 correspond to at least part of the first fins 13, allowing the two fan components 14 to generate cooling airflow to cool the heat dissipation plate assembly 11. These second fins 15, for example, could be made of copper; however, it is not limited.

In the present embodiment, the cooling device 10 may further include two thermal blocks 16. The two thermal blocks 16 are disposed on the first plate 111 and respectively correspond to the first fins 13 located on the first heat absorption section C11 and the second heat absorption section C19. The two thermal blocks 16 are thermally coupled to the two main heat sources H1, respectively. The inclusion of the thermal blocks 16 enhances the efficiency of heat conduction from the main heat sources H1 to the first plate 111.

In the present embodiment, the first heat absorption section C11 and the second heat absorption section C19 have multiple concave-convex structures, and their recessed depths are greater than those of the first heat dissipation section C13, the second heat dissipation section C14, the third heat dissipation section C16, the fourth heat dissipation section C17, the first connecting section C12, the second connecting section C15, or the third connecting section C18. In this way, in addition to enhancing the structural strength of the heat dissipation channel C1, when the cooling device 10 is thermally coupled to the main heat sources H1, the secondary heat sources H2, or other heat sources (not illustrated) disposed on a circuit board (not illustrated), the recessed areas of the first heat absorption section C11, the first connecting section C12, the first heat dissipation section C13, the second heat dissipation section C14, the second connecting section C15, the third heat dissipation section C16, the fourth heat dissipation section C17, the third connecting section C18, and the second heat absorption section C19 can closely adhere to the heat sources. This allows the heat dissipation channel C1 to dissipate heat from the main heat sources H1, the secondary heat sources H2, and other heat sources more efficiently.

In the present embodiment, the configuration of the heat dissipation channel C1 includes the first heat absorption section C11, the first connecting section C12, the first heat dissipation section C13, the second heat dissipation section C14, the second connecting section C15, the third heat dissipation section C16, the fourth heat dissipation section C17, the third connecting section C18, and the second heat absorption section C19; however, this embodiment is not limited. In other embodiments, the configuration of the heat dissipation channel may also be adjusted depending on the internal layout of different electronic devices.

In the present embodiment, the number of ventilation ports P3 and the number of fan components 14 are both two, but this is not limited. In other embodiments, the number of ventilation ports and fan components may each be three or more, or just one.

In the present embodiment, the number of main heat sources H1 and the number of thermal blocks 16 are both two, but this is not limited. In other embodiments, the number of main heat sources and thermal blocks may each be three or more, or just one.

Referring to Figure 5, Figure 5 is a plan view showing the flow of cooling liquid within the heat dissipation channel of the cooling device shown in Figure 1. In this embodiment, the heat dissipation plate assembly 11 of the cooling device 10 is thermally coupled to the heat sources H1 and H2. In some embodiments, the first heat absorption section C11 and the second heat absorption section C19 may be respectively thermally coupled to the two main heat sources H1 while the second connecting section C15 may be thermally coupled to the secondary heat source H2. Then, the pump 12 drives the cooling liquid to circulate within the heat dissipation channel C1.

In some examples, the pump 12 drives the cooling liquid to flow in direction A from the inlet P1 into the first heat absorption section C11. In the first heat absorption section C11, the cooling liquid absorbs heat transferred from one of the main heat sources H1 to the heat dissipation plate assembly 11. Then, the cooling liquid flows in direction B from the first heat absorption section C11 into the first connecting section C12. Subsequently, the cooling liquid flows in direction C from the first connecting section C12 into the first heat dissipation section C13, where it dissipates the absorbed heat via the first fins 13 and the fan component 14. The cooling liquid then flows in direction D from the first heat dissipation section C13 into the second heat dissipation section C14, continuing to dissipate the absorbed heat via the first fins 13 and the fan component 14.

The cooling liquid then flows from the second heat dissipation section C14 into the second connecting section C15, where it moves in direction E. At this point, the cooling liquid absorbs heat transferred from the secondary heat source H2 to the heat dissipation plate assembly 11. Then, the cooling liquid flows from the second connecting section C15 into the third heat dissipation section C16, where it dissipates the absorbed heat again via the first fins 13 and the fan component 14. The liquid continues to move in direction F from the third heat dissipation section C16 into the fourth heat dissipation section C17, dissipating more absorbed heat in the same way. Moving forward, the cooling liquid flows in direction G from the fourth heat dissipation section C17 into the third connecting section C18, and then in direction H from the third connecting section C18 into the second heat absorption section C19. In the second heat absorption section C19, the cooling liquid absorbs heat transferred from the other main heat source H1 to the heat dissipation plate assembly 11. Eventually, the cooling liquid flows in direction I from the second heat absorption section C19 into the outlet P2, where it returns to the pump 12 to initiate another cooling cycle. Hence, continuous heat dissipation can be achieved for heat sources H1 and H2.

According to the embodiment above, because the cooling device includes the heat dissipation plate assembly and the heat dissipation channel is formed through the recessed structure of the first plate of the heat dissipation plate assembly, the bent sections of the flow channel do not take considerable space within the electronic device due to structural constraints. This allows for the design of a more intricate heat dissipation pathway, optimizing the internal space of the electronic device without compromising the placement of other electronic components. This approach enhance utilization of space within the electronic device while maintaining the cooling efficiency of the cooling device 10.

In some embodiments, a method for manufacturing a cooling device includes positioning heat transfer blocks, such as first fins 13, between a first plate 111 and a second plate 112. The first plate 111 and the second plate 112 are then clamped together, with the first fins 13 disposed in between. In some embodiments, the clamped assembly above is further subjected to diffusion bonding in a high-temperature furnace, resulting in an integral, unitary structure where the first plate 111, the second plate 112, and first fins 13 are permanently joined. In some embodiments, at least, one of the first plate 111 and the second plate 112 is further made by stamping from sheet metal material to form corresponding stamped parts. This approach benefits the introduction of structural features during fabrication. In some embodiments, after diffusion bonding, second fins 15 may be attached to an external surface of the bonded structure via low-temperature soldering. In some embodiments, the diffusion bonding is performed at a temperature higher than that used for the soldering.

In some embodiments, the first and second plates 111 and 112 are separately formed as individual parts to allow for diffusion bonding, a high-temperature solid-state welding process. In some embodiments, during assembly, first and second plates 111 and 112 are clamped together with heat transfer blocks (e.g., first fins 13) disposed between them. The clamped assembly is then further placed into a diffusion bonding furnace, resulting in a single, integral unit in which first fins 13 is securely enclosed. After the diffusion bonding process, heat sink component, for example second fins 15, is mounted onto the exterior of the bonded 111-112-13 structure using low-temperature soldering, such as tin-based soldering. The second fins 15 facilitates dissipation of external heat.

In some embodiments, the first plate 111 may include one or more raised bosses configured to contact a heat-generating element, such as a semiconductor die, to enhance thermal transfer. In some embodiments, the second plate 112 may be formed as a substantially flat surface, as it does not immediately engage with the heat source, thereby streamlining its structural specifications.

In some embodiments, it is unfeasible to integrate first and second plates 111 and 112 as a one single-piece structure because first fins 13 must be placed and secured between them before welding. In addition, the separate configuration could allow first fins 13 to be secured within the cavity formed by the first and second plates 111 and 112.

In some embodiments, the first plate 111 is positioned as the upper portion of the assembly and features raised protrusions (bosses) to facilitate immediate engagement with the heat source (*e.g.*, a semiconductor die). In some embodiments, second plate 112, which does not immediately engage with the heat source, is configured as a flat structure.

In some embodiments, pump securing structures 111a, 111b, 111c of the first plate 111 serve both to stabilize the position of a pump and to provide mechanical protection.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A heat dissipation plate assembly (11) comprising:
a first plate (111) having a recessed structure (1111) and being configured for thermal coupling to at least one heat source (H1); and
a second plate (112) covering the recessed structure (1111) to form a heat dissipation channel (C1), a liquid inlet (P1), and a liquid outlet (P2), the heat dissipation channel (C1) being used to contain cooling liquid, and the liquid inlet (P1) and the liquid outlet (P2) being in fluid communication with a heat dissipation channel (C1).

2. A cooling device (10) containing a cooling liquid comprising:
a heat dissipation plate assembly (11) according to claim 1; and
a pump (12) in fluid communication with the liquid inlet (P1) and the liquid outlet (P2), the pump (12) being configured to circulate the cooling liquid within the heat dissipation channel (C1).

3. The cooling device (10) of claim 2, wherein the heat dissipation channel (C1) includes a first heat absorption section (C11) and a first heat dissipation section (C13), a first end of the first heat absorption section (C11) being in fluid communication with the liquid inlet (P1), a second end of the first heat absorption section (C11) being in fluid communication with a first end of the first heat dissipation section (C13).

4. The cooling device (10) of claim 3, wherein a second end of the first heat dissipation section (C13) being in fluid communication with the liquid outlet (P2).

5. The cooling device (10) of claim 3, wherein the heat dissipation channel (C1) further includes a second heat dissipation section (C14), a second end of the first heat dissipation section (C13) being in fluid communication with a first end of the second heat dissipation section (C14).

6. The cooling device (10) of claim 5, wherein a width of the second heat dissipation section (C14) is greater than a width of the first heat dissipation section (C13).

7. The cooling device (10) of claim 5 or 6, wherein a second end of the second heat dissipation section (C14) is in fluid communication with the liquid outlet (P2).

8. The cooling device (10) of claim 5 or 6, wherein the heat dissipation channel (C1) further includes a third heat dissipation section (C16) and a second heat absorption section (C19), a first end of the third heat dissipation section (C16) being in fluid communication with a second end of the second heat dissipation section (C14), a second end of the third heat dissipation section (C16) being in fluid communication with a first end of the second heat absorption section (C19), and a second end of the second heat absorption section (C19) being in fluid communication with the liquid outlet (P2).

9. The cooling device (10) of claim 5 or 6, wherein the heat dissipation channel (C1) further includes a third heat dissipation section (C16), a fourth heat dissipation section (C17), and a second heat absorption section (C19), a first end of the third heat dissipation section (C16) being in fluid communication with a second end of the second heat dissipation section (C14), a second end of the third heat dissipation section (C16) being in fluid communication with a first end of the fourth heat dissipation section (C17), and a second end of the fourth heat dissipation section (C17) being in fluid communication with a first end of the second heat absorption section (C19), and a second end of the second heat absorption section (C19) being in fluid communication with the liquid outlet (P2).

10. The cooling device (10) of claim 9, wherein a width of the third heat dissipation section (C16) is greater than a width of the fourth heat dissipation section (C17).

11. The cooling device (10) of claim 9 or 10, wherein the heat dissipation channel (C1) further includes a first connecting section (C12), a second connecting section (C15), and a third connecting section (C18), the first connecting section (C12) connecting the first heat absorption section (C11) and the first heat dissipation section (C13), the second connecting section (C15) connecting the second and third heat dissipation sections (C14, C16), and the third connecting section (C18) connecting the fourth heat dissipation section (C17) and the second heat absorption section (C19).

12. The cooling device (10) of claim 11, wherein a recessed depth of the first heat absorption section (C11) or the second heat absorption section (C19) is greater than a recessed depth of the first, second, third, or fourth heat dissipation section (C13, C14, C16, C17), as well as the first, second, or third connecting section (C12, C15, C18).

13. The cooling device (10) of one of claims 9 to 12, further comprising a plurality of first fins (13), each disposed on the first heat absorption section (C11), the first, second, third, and fourth heat dissipation sections (C13, C14, C16, C17), and the second heat absorption section (C19).

14. The cooling device (10) of claim 13, further comprising at least one thermal block (16), disposed on the first plate (111) and corresponding to the first fins (13) located on either the first or second heat absorption section (C11, C19), the at least one thermal block (16) being configured for thermal coupling to the at least one heat source (H1).

15. The cooling device (10) of claim 13 or 14, further comprising at least one fan component (14), wherein the first plate (111) and the second plate (112) together form at least one ventilation port (P3), the ventilation port (P3) being separate from the heat dissipation channel (C1), and the fan component (14) is disposed at the ventilation port (P3).

16. The cooling device (10) of claim 15, further comprising a plurality of second fins (15), disposed on the first plate (111), wherein the fan component (14) includes a base (141) and two side portions (142), the two side portions (142) being connected to the base (141) and adjacent to each other, the base (141) having an air inlet (1411), and each of the two side portions (142) having an air outlet (1421), the second fins (15) being respectively located adjacent to the air outlet (1421) of the fan component (14) and corresponding at least in part to the first fins (13).

17. A method of manufacturing a cooling device (10), comprising:
positioning a first plate (111) and a second plate (112), wherein the first plate (111) comprises a recessed structure (1111) configured for thermal coupling to at least one heat source (H1);
disposing a plurality of first fins (13) between the first plate (111) and the second plate (112);
clamping the first plate (111) and second plates (112) together with the first fins (13) disposed therebetween;
performing diffusion bonding on the clamped first (111) and second plates (112) to form:
a heat dissipation channel (C1) configured to contain cooling liquid;
a liquid inlet (P1) in fluid communication with the heat dissipation channel (C1); and
a liquid outlet (P2) in fluid communication with the heat dissipation channel (C1).

18. The method of claim 17, further comprising:
soldering a plurality of second fins (15) to an external surface of the bonded first (111) and second plates (112).

19. The method of claim 17 or 18, further comprising:
mounting at least one fan component (14) at a ventilation port (P3) formed by the first (111) and second plates (112), wherein the ventilation port (P3) is separate from the heat dissipation channel (C1).

20. The method of one of claims 17 to 19, further comprising:
coupling a pump (12) in fluid communication with the liquid inlet (P1) and the liquid outlet (P2), wherein the pump (12) is configured to circulate the cooling liquid through the heat dissipation channel (C1).
